Europäisches Patentamt

European Patent Office

Office européen des brevets

(19)

(11) Publication number: **0 112 998**
**B1**

# (12) EUROPEAN PATENT SPECIFICATION

(45) Date of publication of patent specification: **06.05.87**

(51) Int. Cl.⁴: **H 01 L 21/66**

(21) Application number: **83110968.1**

(22) Date of filing: **03.11.83**

(54) System of electrically testing integrated circuit yield detractors.

(30) Priority: **29.12.82 US 454222**

(43) Date of publication of application:
**11.07.84 Bulletin 84/28**

(45) Publication of the grant of the patent:
**06.05.87 Bulletin 87/19**

(84) Designated Contracting States:
**DE FR GB**

(56) References cited:
**DE-A-2 707 612**
**FR-A-2 356 949**
**US-A-3 774 088**
**US-A-4 413 271**
**INTERNATIONAL ELECTRONIC CIRCUIT PACKAGING SYMPOSIUM (IECP)-Symposium Record, vol. 10, part 7/4, August 20-21, 1969, San Francisco (US), F. MILLER: "Test sites for microelectronics", pages. 1-10**
**ELECTRONICS, vol. 41, no. 15, July 22, 1968, New York (US), F.J. BARONE et al.: "Getting beneath the surface of multilayer integrated circuits", pages 84-88**

(73) Proprietor: **International Business Machines Corporation**
**Old Orchard Road**
**Armonk, N.Y. 10504 (US)**

(72) Inventor: **Magdo, Steven**
**Frances Drive**
**Hopewell Junction, N.Y. 12533 (US)**
Inventor: **Satya, Akella Venkata Surya**
**38 Tor Road**
**Wappingers Falls, N.Y. 12590 (US)**

(74) Representative: **Gaugel, Heinz, Dipl.-Ing.**
**Schönaicher Strasse 220**
**D-7030 Böblingen (DE)**

EP 0 112 998 B1

## Description

This invention is related to the testing of multiple layered integrated circuit structure. In particular, it relates to test circuits corresponding to, or salient models of devices produced by discrete fabrication process steps and fabricated concurrently with the actual circuits to determine the origin and density of device defects arising during fabrication.

In the fabrication of integrated circuits, a large number of masking, etching and temperature application steps are required to produce a final device. Each of these steps produces its own characteristic defect which in turn contribute to the yield rate of the overall process. It has become common to fabricate test structures during the manufacturing process which serve to provide reliability data on IC circuits. These test circuits are separately fabricated to the point of defining a complete device, then tested. However, the integrated circuits themselves cannot be probed since the inner connections of the impurity regions in the device as formed are not electrically accessible. Additionally the regions cannot be isolated from one another to provide accurate data of particular defect causing mechanisms. Hence, at the end of the processing sequence, it is not possible to separate defects by type or discrete mechanism (i.e., processing step) to determine the origin from the product tested.

As is well known, contemporary monolithic integrated circuits utilize a dense pattern of impurity regions and interconnecting metallurgy such that the components per se cannot be readily isolated for purposes of testing. Thus, as set forth, for example, in US—A—3 507˙036, it has become necessary to design test structures which are physically isolated from the production circuits yet are subjected to the same processing steps which can be individually tested. In accordance with the teachings of the '036 patent, a test site is described which is a representative structure designed closely to simulate the real product produced during processing. However, this type of structure requires a large number of outgoing contacts, the testing is multipass and complicated; it does not cover enough semiconductor area. Accordingly, it is relatively ineffective for detecting and monitoring low level manufacturing defects which are the hallmark of contemporary IC products. At present there is no single monitoring test structure which is capable of determining all defect densities by type without the requirement of extensive implementation and costly repeated test and analysis.

The prior art is replete with a number of other proposals defining complex test structures that accurately model the actual IC circuits and attempt to provide defect monitors for various levels. These test devices seek to provide data indicative of the processing steps causing the defect. US—A—4 144 493 defines a test structure having elongated, serpentine transistor sections. These long-stretched transistors theoretically provide data vis-a-vis defect densities, however, they are not present in the product. Thus their defect types and densities are not necessarily the same as those of the product. In addition, these structures do not provide defect data on contacts.

Another test site approach utilizes photodefect detector analysis. In accordance with this proposed method, product wafers are removed from the master at various levels of processing. The wafers are then personalized to limited specific test structures with respective contacts and metal patterns and are tested and analyzed for fault densities at various masterslice levels. Such an approach requires significant additional processing and the use of several and different masks test programs and data analysis routines. Implementation on a high volume product is therefore difficult.

Yet another test structure philosophy utilizes the so-called universal manufacturing test site and product test site approach. These manufacturing test sites are identical to the product up to the metal interconnections. Thus the structures fabricated in the silicon, such as transistors, resistors and Schottky diodes are identical to those in the product. The metal interconnections of the test site, however, are customized in order to wire up some of the transistors and Schottky diodes into parallel chains on a portion of the test site. The other portion of the test site is reserved for the metal test structures, such as serpentines and via hole chains. The manufacturing test sites have the following shortcomings:

(1) Photo defects for the silicon structures (masterslice), such as resistors, lateral PNP transistors, contact package, missing isolation are not monitored;

(2) Critical area of monitoring structures such as transistor chains, Schottky diode chains, etc., is low;

(3) Defects from other mask levels interfere with monitoring;

(4) The topology of metal test structures is different from that of the product.

Reference is made to Electronics, Vol. 41, July 22, 1968, pp. 84—88.

Additional test structure prior art forming a background to this invention is found in US—A—3 762 037; US—A—3 774 088; and US—A—3 849 872.

Reference is made to IBM Technical Disclosure Bulletin Numbers Vol. 13, No. 7, December 1970, p. 1793; Vol. 18, No. 6, November 1975, p. 1935; and Vol. 20, No. 4, September 1977, pp. 1418—1419. Additional prior art deemed less pertinent is typified by US—A—3 650 020 and US—A—3 781 670.

The hallmark deficiencies of these proposed test sites can be briefly summarized. Many of the proposals lack the necessary sensitivity with the actual product being produced. That is, they are not adequate models of the actual device itself. Moreover, in other proposals attempting to define the necessary product sensitivity, the patterns become so complex that there is a high probability of interfering failure within the pattern itself. That is, the test pattern becomes so complex that it may fail itself for reasons not associated with the actual mechanism under test. Other proposals do not utilize single level metallurgy and accordingly the connections to each test site cannot be brought to a non-interfering personality wiring facilitating a single pass electrical testing. Multiple passes generate large amounts of data, most of which is redundant.

Significantly, the prior art proposal does not allow each test site region to be subjected to the same environmental cycles as used to make the actual product. For example, in the photodefect detector concept, product wafers are withdrawn from the process after desired process steps occur. Thus, failure mechanisms which are enhanced by subsequent processing steps cannot be identified. This technique therefore makes it impossible to identify different failure mechanisms with identity to the product device.

It is therefore an object of this invention to define an improved unified test site that blocks off selected masking levels other than those which lead to a specific defect type. This object of the invention allows for semiconductor defect monitoring that tests for defects which occur in the manufacture of highly complex semiconductor devices at various processing stages by subjecting the test site to all thermal process steps.

An additional object of this invention is to define a technique of editing the product structure to identify salient defect-contributing structure and then defining a highly densified structure replicating this structure as a test site.

Another object of this invention is to provide a test site that provides an indication of defects of a product chip at significant processing steps without interference from other processing steps. Hence a "snap-shot" of a defect occuring at a particular process step is obtained.

Yet another object of this invention is to provide a defect monitor wherein connections for each test site are brought up to a common level in order to facilitate single pass electrical testing.

A further object of this invention is to provide a defect monitor where testing is by opens or shorts to eliminate testing time and allow for series or parallel connections of devices to be tested.

These and other objects are attained according to this invention by subdividing a portion of the chip into discrete test site areas each monitoring a critical processing step or steps. The test sites may be configured to represent an edited and therefore highly densified test structure having the identical salient structure of the product cell. This allows for testing of the identical structure in a densified array. Each test site is processed up to an indicated level and then subsequent structural processing steps are blocked out. Accordingly, monitoring of an individual layer by electrical faults for example, testing as electrical shorts or opens, can be effectuated without interference of the yield detractors existent in other layers. However the test site is subjected to identical subsequent environmental processing as the product. This invention will be described in greater detail by referring to the description of the preferred embodiment of the invention as illustrated by the accompanying drawings, of which:

Fig. 1A is a plan view of a cell chain;

Fig. 1B is an edited cell with a highly densified test structure;

Fig. 2 is a perspective map showing the various test sites comprising a test structure made in accordance with this invention;

Fig. 3A is a perspective view showing the test site for two mask levels to determine defects in various isolation and subcollector regions;

Fig. 3B is a perspective view of the test site of Fig. 3A following additional processing;

Fig. 4 is a schematic perspective of a second test site in the test structure to detect reach-through defects in the formation of a p-resistor structure;

Fig. 5 is a perspective schematic of a third test site to determine defects related to transistor junctions and Schottky barrier diodes;

Fig. 6 is a modified test site modifying Fig. 3B to form a Schottky contact in an ROI window; and

Fig. 7 is an elevation view showing the layout of the first and second metal of Fig. 2.

The fabrication of a bipolar integrated circuit requires numerous masking, etching, deposition, and thermal steps. Each of these steps produces its own characteristic defect which in turn contributes to a final test-yield for the completed product. The fabrication of integrated circuits is an extremely complex process involving several hundred individual operations extending over a protracted period of time. A basic description is found in U.S. Patent 3 508 209.

The process essentially involves diffusing precisely predetermined minute amounts of impurities, such as phosphorus, arsenic or boron into precisely predetermined areas of a silicon wafer. By utilizing photomask and photoresist technologies, a pattern of areas into which diffusion is to occur is delineated on a silicon dioxide mask formed over the silicon wafer. Openings are then etched through the silicon dioxide to define the pattern of minute areas into which diffusion subsequently takes place. Following a number of such masking, diffusion, oxidation and reoxidation operations, the desired bipolar devices, transistors, diodes and the like, as well as passive devices such as resistors, are created. By techniques such as vacuum evaporation and the like, inner connection lines are defined also utilizing photoresist and photomasking processes.

As is appreciated (see US—A—3 751 647), once defects have been identified, it is highly desirable to reduce the number of such defective products in the manufacturing process to thereby increase the yield of devices meeting specifications. Small increases in yield have significant economic ramifications. However, given the large number of processing operations which may cause a particular defect, there are correspondingly significant difficulties in attempting to delineate the exact critical yield detracting process operation. As set forth herein, prior art techniques, such as visual inspection, the use of test sites and the like have been proposed in order to predict integrated circuit yield on the basis of factors such as defect densities existent in photomasks, photoresist and in the diffusion operations.

The definition of a suitable test structure is crucial for it allows accurate integrated circuit yield modelling to produce predictions which are sufficiently accurate vis-a-vis the identification and change of critical yield detracting process operations. However, many tests are destructive of the test structure and therefore do not permit densification. Moreover, given the mechanical underlayering of the product, defect identification in sub-levels once processing is complete is very difficult and time consuming. Importantly, the prior art removes an intermediate test site before all environmental processing is complete, therefore not environmentally modeling the complete device.

The present invention departs from the prior art by providing a monitoring test device which is capable of determining masterslice and personality defect densities level by level without the requirement of repeated implementation and repeated test analysis. As used therein, the term "masterslice" refers to components embedded into the silicon wafer. "Personality" refers to metallization structures connecting the above-mentioned silicon components.

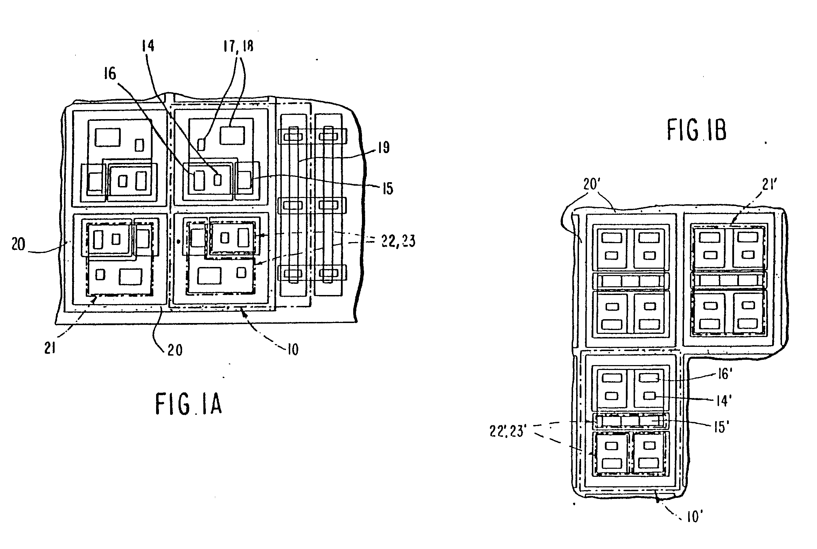

Referring to Fig. 1A, an example of editing the product structure to obtain a densified test site is illustrated. Fig. 1A is a plan view of a portion of a cell chain having Schottky barrier diodes, a transistor and resistor in an original cell 10. The transistor structure 12 comprises an emitter 14 positioned between collector and base contacts 15, 16. The Schottky diodes are shown schematically as elements 17, 18. The P type resistor 19 in the original cell is separated from the transistor and Schottky diodes by an isolation region 20 that extends to separate active portions of the original cell. A subcollector region is defined inside the line 21 shown for identification in an adjacent cell. Within the subcollector are ROI (Recessed Oxide Isolation) windows, one window 22 for the emitter and base contact, and a second window 23 for the collector and the Schottky diodes. It will be appreciated that Fig. 1A illustrates only a portion of the chain, which has groups of active portions with adjacent resistors and isolation for separation.

In analyzing this cell structure for salient defect modes, if a specific structure will contribute to a particular defect type under test, it will be retained but not necessarily monitored. The test site is therefore configured to model the defect contributing structure of the product but the entire site need not be duplicated and monitored. Hence, the defects produced in the test site will be identical to those in the product.

As shown in Fig. 1B, during processing to form the transistor structure, contamination accumulating on a crystal defect, as a consequence of thermal processing to form the ROI cause pipes—which can cause an emitter to collector short. Hence, the emitter-base 14', 16' structure is retained within an ROI area 22' keeping the emitter to ROI separation identical to that of the product. Similarly the collector contact 15' is retained within ROI window 23' to maintain identity with the product. A subcollector 21' is formed around adjacent emitter-base zones with a surrounding isolation region 20'. The edited cell 10', forming the test site identically, replicates the salient transistor structure, separation of isolation and subcollector, and emitter to ROI in an edited manner and with quadruple density, that is a 4:1 densification. Defects between isolation and subcollector are also important from the point of view of pipe formation. If the separation is reduced due to mask misalignment, crystalographic defects may result since high concentration N and P regions are diffused into the same silicon area. In order to separate the pipe defects caused by ROI, in one of the edited test structures the ROI masking is blocked out. The defects occurring in the test site as a result of subjecting it to the same processing steps as the product to create identical structure are therefore retained. Importantly, the densification itself does not contribute to or define a failure mode itself. That is, in processing, subsequent masking steps at the test site are blocked out (i.e. new windows are not opened) but all thermal processing is carried out. The resulting test site is then a "snap-shot" of a particular phase in device formation. Metallization is then brought to a top layer for single pass testing.

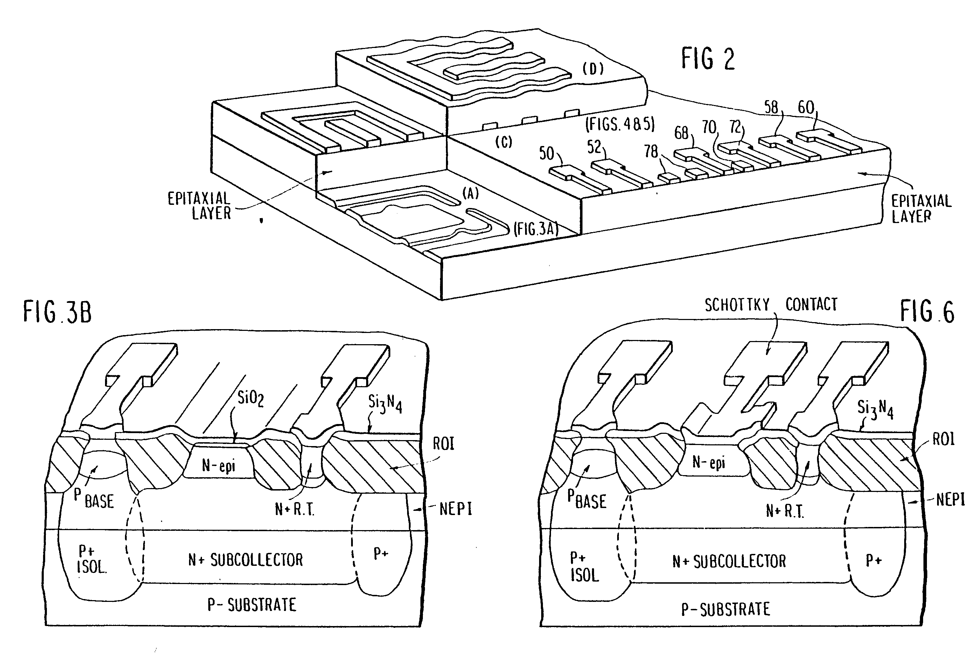

Referring to Fig. 2, a "map" of the test structure defining three test sites is shown. The test sites represent individual test structures into which the masterslice processing is divided such that at crucial levels individual electrical testing can be accomplished. As shown in Fig. 2, four levels are formed. It will be appreciated that the present invention is not limited to four such levels but rather any number can be used to delineate crucial points in device processing. Moreover, the number of test sites per se is also not limited. Importantly, each test site represents structure having defects caused during one or two masking related operations. Electrical test data is therefore severable to represent defects from each significant masking operation. Moreover, a particular level may have several test sites associated with the same processing steps. Given the plurality of levels, masking operations in either subsequent or precedent steps for each product level may then be blocked out in the test structure region of the product design layout except for the contacts and personalization levels. Consequently, all yield detractors from mask operations that are not connected with the particular level in the masterslice region may be prevented from causing interference in the measurement of defect densities associated with that particular region. By using appropriate device yield modeling, for example, as set forth in U.S. Patent 3 751 647, insignificant contributions occurring as a result of personality levels can be appropriately screened.

A preferred embodiment of this invention using four test levels monitoring a crucial processing step or related steps will now be described to illustrate this invention. In order to allow electrical testing to be conducted at a single pass, metallization from each of the regions is brought to an appropriate metal level. It will be appreciated that while not shown, the metallization is brought out to contact pads for testing.

As shown in Fig. 2, two levels of metallization on regions C and D are utilized. The metal topology of the actual product device is retained to test for "opens" due to discontinuities in personalization. The topology is primarily a function of ROI and with the correct topology shorts in the metallization can also be tested in a single pass. This eliminates a significant data handling problem in test modes where redundant data is accumulated in multiple passes. That is, where multiple passes are required, the data produced will be the same for each pass over the same contact until a defect is produced. Hence, in the case of a no defect zone, identical data will be produced for each pass. The number of contacts producing data is, of course, large.

The test structure shown in Fig. 2 can be located either in wafer kerf regions or in sites normally reserved for product chips. In the situation where the evaluation of a new process is required, full wafer testing may be appropriate, employing all chip sites.

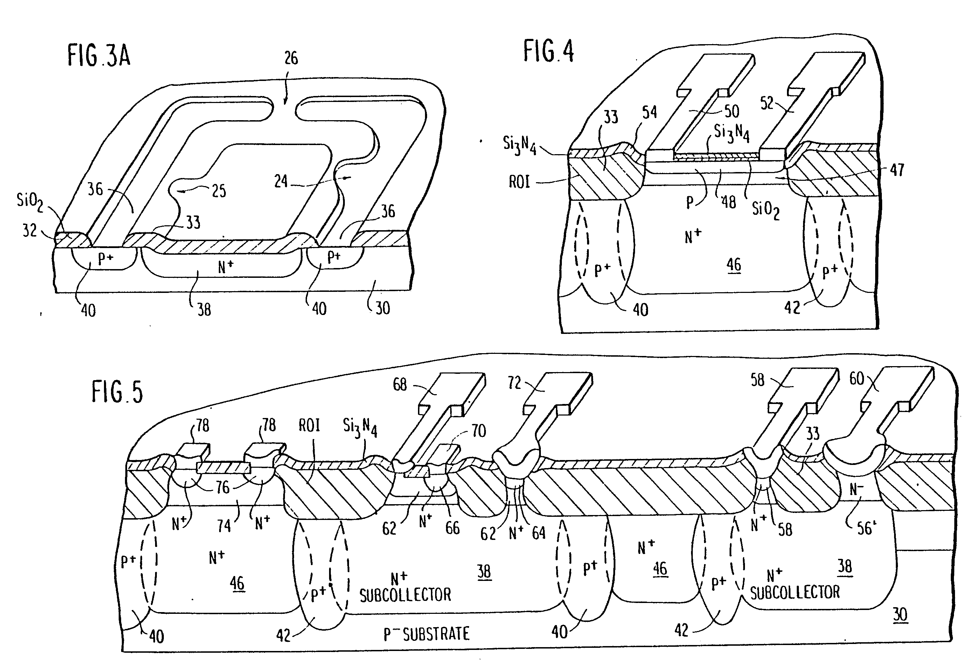

Referring now to Fig. 3A and Fig. 3B, a first test site for detecting defects relative to mask operations for achieving subcollector and isolation regions is shown in a perspective view. This site corresponds to the base level A in Fig. 2. Fig. 3A shows the effect of several defect types. On a $Si(P^-)$ substrate 30, thermal $SiO_2$ 32 is grown. Subcollector areas are then opened with a subcollector mask and subcollector region 38 is formed by $N^+$ diffusion. Then the silicon substrate is reoxidized and isolation area 36 opened with an isolation mask. An isolation region 40 is formed by $P^+$ diffusion. The next processing step is silicon epitaxial layer deposition, which cannot be blocked out. In order to contact both subcollector and isolation regions buried by the epitaxial layer the next two processing steps, collector reach through (R.T.) and isolation contact diffusions have to be also performed. The base and emitter diffusions however are blocked out. The structure including the metallization is shown in Fig. 3B.

Fig. 3A shows several types of defects which may exist. These defects include extended silicon in the isolation region (24) and extended silicon in the subcollector region (25). Also, another salient defect is extended silicon dioxide in the isolation region (26) which is an open isolation pattern. In the test site, test metal is deposited (not shown) defining metallization lines for testing. The chart below summarizes the defect type, the results, the configuration, and test performed.

| Defect type | Result | Configuration | Test |
|---|---|---|---|
| Extended Si in isolation | Coll-Isol | Parallel | Isol-Coll |
| Extended Si subcollector | Short | Collectors | Breakdown |
| Extended $SiO_2$ in isolation | Coll-Coll Short | Two or more chains with parallel collectors | Coll-Coll Breakdown |

As shown in Fig. 3A, a first type of defect (24) is extended silicon in the isolation region 40. This results in a collector-isolator short. The test structure configuration is collectors wired up into a parallel chain and tested against isolation. A second defect (25) as a function of extended Si exists as shown in Fig. 3A into the subcollector region 38. The test structure configuration is the same as before.

An important defect relative to isolation region 40 exists vis-a-vis extended $SiO_2$. If, as shown in Fig. 3A, isolation is missing, a short (26) results between adjacent collectors. The corresponding test structure is two interdigitated collector chains, where each adjacent collector is connected to a different chain. That is, the collectors alternate their connections to a different chain.

In Fig. 3A and Fig. 3B a difference in level 33 exists between the $SiO_2$ layer over the subcollector 38 and over the isolation regions. This occurs due to reoxidation in preceding steps.

Referring now to Fig. 4, a test site relating to different mask levels that are processed for forming a P resistor is shown. In the preceding processing steps, subcollector regions 38 are defined bounded by $P^+$ isolation regions 40, 42. Subsequent processing steps result in the deposition of silicon epitaxial layer 47 and formation of ROI. Then, P type resistors shown in Fig. 1 are formed using ion implantation. The resistor structure is shown as element 48. In the corresponding test structure the resistors are connected in series for probing opens and shorts.

A test structure similar to that shown in Fig. 4 is used for "P" contact integrity monitoring. For this case however, the "P" contact resistor is wide and short (as opposed to long and narrow as illustrated) to eliminate interfering resistor defects such as opens. The resistor is formed by using diffusion techniques.

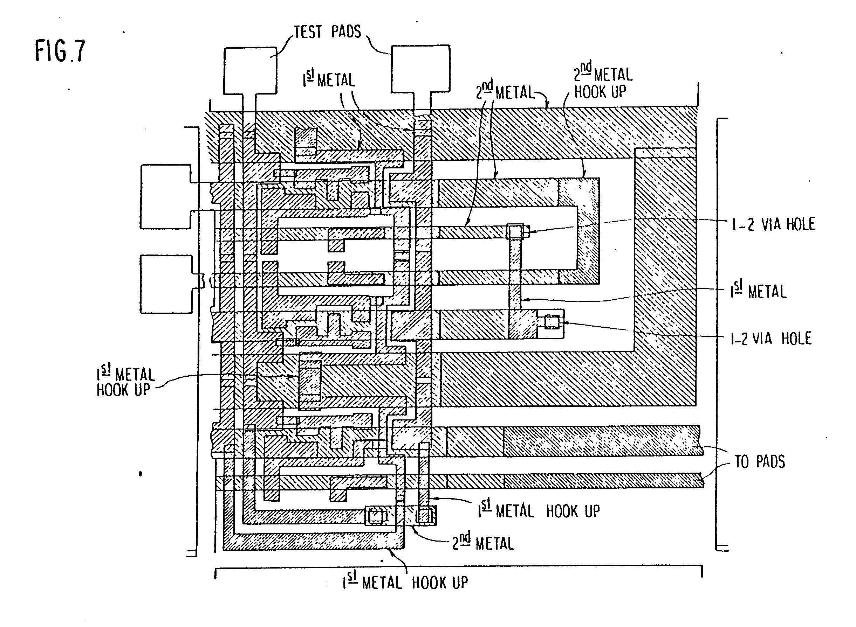

Fig. 5 illustrates a third test site at the same level as that in Fig. 4. As shown, the $P^+$ diffusions 40 and 42 bound $N^+$ subcollector regions 38 in the substrate 30. This test site forms active elements, a Schottky diode, transistor and emitter contact monitor. The Schottky diode is formed by openings in the ROI 32 and $Si_3N_4$ 54 having $N^-$ epitaxial regions 56 with appropriate contacts 58, 60. The transistor structure is formed by opening areas in the ROI and $Si_3N_4$ for a P base diffusion 62 followed by selective $N^+$ diffusions to define a collector region 64 and an emitter region 66. Appropriate metallization then defines the transistor contacts, a base contact 68, an emitter contact 70 and a collector contact 72. The test site also includes an emitter contact monitor formed by $N^+$ diffusion 76 in an isolated $N^-$ epitaxial region 74. Appropriate contacts 78 then define an $N^+$ epi resistor structure.

The transistors are edited to obtain a densified transistor test site as shown in Fig. 1, where the

**0 112 998**

transistors are wired up into a parallel chain. By testing the leakage currents and breakdowns, junction defects and pipes can be monitored. Similarly the Schottky diodes are edited to obtain a densified Schottky diode chain with a parallel connection. By testing leakage currents and breakdowns, Schottky junction defects can be monitored. In order to increase density, the Schottky diode test structure in Fig. 5 can also be merged with the test structure shown in Fig. 3B by forming a Schottky contact in the ROI window as shown in Fig. 6. These two structures will not interfere with each other. Other defect types include extensions of $SiO_2$ into the contact areas. These defects, the result, device configuration and test are summarized in the following chart.

| Defect type | Result | Test configuration | Test |
|---|---|---|---|
| Defects in Schottky junction | Short | Parallel | Breakdown, leakage |
| Extended $SiO_2$ contacts | High cont. res. | Em contacts | Voltage drop or open |
| Defects in transistor junction | Short | · Parallel transistors | Breakdown, leakage |

Referring again to Fig. 2, test sites C and D represent the first and second metallization levels, respectively, for the product. Following application of the serpentine first metal layer (shown only partially), a sputtered layer of $SiO_2$ is applied over the metal lines. The second level is then applied. Hence the level difference between layers C and D results.

The more detailed layout of the first and second metal is shown in Fig. 7. As can be seen, the product metal (both first and second level) is hooked up into serpentines so that opens, intralevel shorts and interlevel shorts can be monitored. The underlaying silicon structure is identical to the product except that silicon contacts are not opened to eliminate interference. Test pads are disposed on the peripheral portions of the metallization. The hook-ups and techniques of bringing this metallization to the top layer are well known in this technology. Shorts and opens for each level can be tested. By maintaining the same metallization as in the device, including the topology, interlevel shorts and opens can also be tested.

While this invention has been described in the context of a test site having a single passive element (P resistor) and a second site with a Schottky diode and transistor, it is apparent that the invention is not so limited. Rather, the test devices can be configured in a variety of ways dependent only on maintaining defect identity to the actual product. The test site is then "snap-shot" of the defects of a product chip caused by every critical processing step without the interference of other processing steps. This is accomplished by blocking off masking levels other than those related to the defect type and subjecting each test site to the same heat cycle as the product.

Moreover, while a multilevel device is shown, the number of layers is not critical since the connections from each test site region are brought up to the top level in order to facilitate single pass electrical testing. Given the ability to devise a multilevel structure, the individual snap-shots of product chip defects, which are processed on top of each other in the product, are spread out horizontally as individual test site regions.

**Claims**

1. A test device in a semiconductor substrate (30) having a plurality of electronic devices (10) of an integrated circuit fabricated therein, the test device provided to detect defects arising during the process of forming the devices in the substrate, comprising:

one or more test regions (Fig. 4) in the substrate (30) containing one or more test structures (40—48), a test structure of at least a particular region corresponding to an intermediary form of an electronic device fabricated on the substrate, the test structures of the different intermediary forms being masked so that subsequent processing steps are blocked out, and

a metallization pattern for each said test region having conductive elements (50, 52) for selectively electrically interconnecting said test structures, and contact pads electrically connected to the conducting elements, the pads adapted to be contacted by test apparatus to permit electrical testing of the structure.

2. The test device of claim 1, wherein said test regions are at different levels of said substrate (10) and said respective metallization patterns are disposed at the levels of the metallization patterns for said electronic devices.

3. The test device of claim 1 or 2, wherein said test region comprises a densified array of defect-causing components of a semiconductor device positioned to replicate said device.

4. A method for making a test device in a semiconductor substrate, the substrate having a plurality of semiconductor devices of an integrated circuit fabricated therein, the method comprising:

a. forming a first intermediate semiconductor test structure at one or more test regions of the substrate corresponding to a first intermediate form of a device being fabricated on the substrate,

6

# 0 112 998

b. successively masking precedingly formed intermediate test structures in such a way that the subsequent structure processing steps are blocked out, and forming further subsequent intermediate test structures at other regions until the device being formed is completed, the further subsequent test structures corresponding to subsequent intermediate forms of the device being fabricated, and

c. metallizing the intermediate test structures of the one or more test regions to permit interconnections and isolation thereof for electrical test.

## Patentansprüche

1. Testvorrichtung in einem Halbleitersubstrat (30) mit mehreren elektronischen Vorrichtungen (10) einer darin hergestellten integrierten Schaltung, wobei die Funktion des Testgerätes darin besteht, während des Herstellungsprozesses der Vorrichtung im Substrat entstehende Fehler zu erkennen, folgendes enthaltend:

einen oder mehrere Testbereiche (Fig. 4) im Substrat (30) mit einer oder mehreren Teststrukturen (40—48), wobei eine Teststruktur von mindestens einem bestimmten Bereich einer Zwischenform einer auf dem Substrat hergestellten elektronischen Vorrichtung entspricht, und wobei die Teststrukturen der verschiedenen Zwischenformen mit einer Maske versehen sind, sodaß nachfolgende Verfahrensschritte ausblockiert sind, sowie

ein Metallisierungsmuster für jeden dieser Testbereiche, mit leitenden Elementen (50, 52) für das wahlweise stattfindende elektrische Verbinden der Teststrukturen untereinander, und mit Kontaktstellen, welche elektrisch mit den leitenden Elementen verbunden sind, und mit denen vom Testapparat ein Kontakt hergestellt werden kann, um das elektrische Testen der Struktur zu ermöglichen.

2. Testvorrichtung nach Anspruch 1, worin die Testbereiche sich auf verschiedenen Stufen des Substrats (10) befinden, und worin die entsprechenden Metallisierungsmuster auf den Stufen der Metallisierungsmuster für die elektronischen Bereich vorgesehen sind.

3. Testvorrichtung nach Anspruch 1 oder 2, worin der Testbereich eine verdichtete Anordnung von fehlerverursachenden Komponenten einer Halbleitervorrichtung enthält, die zur Duplizierung der Vorrichtung angeordnet ist.

4. Verfahren zum Herstellen einer Testvorrichtung in einem Halbleitersubstrat, wobei das Substrat mehrere Helbleitervorrichtungen einer darin hergestellten integrierten Schaltung aufweist, folgende Schritte umfassend:

a. Herstellen einer ersten Zwischenhalbleiter-Teststruktur an einem oder mehreren Testbereichen des Substrats, die einer ersten Zwischenform einer auf dem Substrat hergestellten Vorrichtung entspricht,

b. fortlaufendes Maskieren von zuvor geformten Zwischenteststrukturen, auf solche Weise, daß die nachfolgenden Strukturverarbeitungsschritte ausblockiert sind, und Herstellen weiterer nachfolgender Zwischenteststrukturen bei anderen Bereichen, bis die so gebildete Vorrichtung abgeschlossen ist, wobei die weiteren anschliessenden Teststrukturen anschließenden Zwischenformen der herzustellenden Vorrichtung entsprechen, sowie

c. Metallisieren der Zwischenteststrukturen von einem oder mehr Testbereichen, um Verbindungen und deren Isolierung für elektrische Tests zu ermöglichen.

## Revendications

1. Dispositif de test dans un substrat semiconducteur (30) muni d'une pluralité de dispositifs électroniques (10) d'un circuit intégré qui y est fabriqué, le dispositif de test étant prévu pour détecter des défauts servenant pendant le processus de fabrication des dispositifs dans le substrat, comprenant:

une ou plusieurs zones de test (figure 4) dans le substrat (30) contenant une ou plusieurs structures de test (40—48), une structure de test d'au moins une zone particulière correspondant à une forme intermédiaire d'un dispositif électronique fabriqué sur le substrat, les structures de test des différentes formes intermémdiaires étant masquées de sorte que des étapes de traitement ultérieures soient bloquées, et

un motif de métallisation pour chaque zone de test comprenant des éléments conducteurs (50, 52) pour interconnecter électriquement sélectivement les structures de test, et des plots de contact connectés électriquement aux éléments conducteurs, les plots étant adaptés à entrer en contact avec un appareil de test pour permettre de tester électriquement la structure.

2. Dispositif de test selon la revendication 1, dans lequel les zones de test sont à des niveaux différents du substrat (10) et les motifs de métallisation respectifs sont disposés aux niveaux des motifs de métallisation pour ces dispositifs électroniques.

3. Dispositif de test selon la revendication 1 ou 2, dans lequel la zone de test comprend un réseau densifié de composants provoquant des défauts d'un dispositif semiconducteur placé pour dupliquer ledit dispositif.

4. Procédé pour fabriquer un dispositif de test dans un substrat semiconductor, le substrat possédant une pluralité de dispositifs semiconducteurs d'un circuit intégré qui y est fabriqué, le procédé comprenant les étapes suivantes:

a. fabriquer une première structure de test semiconductrice intermédiaire en une ou plusieurs zones de test du substrat correspondant à une première forme intermédiaire d'un dispositif en cours de fabrication sur le substrat;

b. successivement masquer des structures de test intermédiaires précédemment fabriquées de façon que les étapes de traitement d'une structure ultérieure soient bloquées, et fabriquer d'autres structures de test intermédiaires ultérieures en d'autres zones jusqu'à ce que le dispositif en cours de fabrication soit achevé, les autres structures de test ultérieures correspondant à des formes intermédiaires ultérieures du dispositif en cours de fabrication; et

c. métalliser les structures intermédiaires de test de ladite une ou plusieurs zones de test pour permettre des interconnexions et une isolation de celle-ci pour un test électrique.

FIG.1A

FIG.1B

0 112 998

FIG 2

EPITAXIAL LAYER

58 60

68 70 72

78

52

50

(D)

(C)

(A)

(FIGS. 4 & 5)

(FIG. 3A)

EPITAXIAL LAYER

FIG. 6

SCHOTTKY CONTACT

Si₃N₄

ROI

NEPI

N-epi

N+R.I.

P+

P$_{BASE}$

P+ ISOL

N+ SUBCOLLECTOR

P-SUBSTRATE

FIG. 3B

SiO₂

Si₃N₄

ROI

NEPI

N-epi

N+R.I.

P+

P$_{BASE}$

P+ ISOL.

N+ SUBCOLLECTOR

P-SUBSTRATE

FIG.3A

26

SiO₂
32
36
25
33
24
36

P+  N⁺  P+
40  38  40  30

FIG.4

33  54
Si₃N₄  50  52
Si₃N₄
ROI
P  48  SiO₂  47
N⁺
P+  46  P+
40  42

FIG.5

68  72
78  78  ROI  Si₃N₄  70  58  60
76  33
N⁺  74  N⁺  62  N⁺  66  62  N⁺  64  N⁺  58  N⁻  56
P+  N⁺  P+  P+  N⁺  P+  N⁺  56
46  N⁺  38  46  38
SUBCOLLECTOR  SUBCOLLECTOR
40  42  P⁻SUBSTRATE  40  42  30

0 112 998

3

FIG.7

TEST PADS

1ˢᵗ METAL

2ⁿᵈ METAL

2ⁿᵈ METAL HOOK UP

I-2 VIA HOLE

1ˢᵗ METAL

I-2 VIA HOLE

1ˢᵗ METAL HOOK UP

TO PADS

1ˢᵗ METAL HOOK UP

2ⁿᵈ METAL

1ˢᵗ METAL HOOK UP

0 112 998